# FASCICULE DE BREVET EUROPEEN

(11) **EP 3 425 757 B1**
(45) Date de publication et mention de la délivrance du brevet: **02.06.2021**
(21) Numéro de dépôt: 18180160.6
(22) Date de dépôt: 27.06.2018
(51) Int. Cl.: H02H 3/00, H02H 3/06, H02H 3/20

(54) **CIRCUIT DE PROTECTION D'UN COMMUTATEUR DE PUISSANCE**
SCHUTZSCHALTUNG FÜR EINEN SCHALTER
PROTECTIVE CIRCUIT FOR A POWER SWITCH

(30) Priorité: 07.07.2017 FR 1756437
(43) Date de publication de la demande: 09.01.2019
(73) Titulaire: STMICROELECTRONICS (ROUSSET) SAS, 13790 Rousset (FR)
(72) Inventeur: BIENVENU, Philippe, 83470 SAINT MAXIMIN (FR); CALANDRA, Antonio, 13090 AIX EN PROVENCE (FR)
(74) Mandataire: Cabinet Beaumont

(56) Documents cités:
- EP-A1- 0 546 963
- EP-A1- 0 678 751
- WO-A1-2017/062715
- WO-A2-2014/199100
- FR-A1- 2 895 115
- US-A1- 2014 055 119
- US-A1- 2017 033 552

## Description

### Domaine

La présente description concerne de façon générale les circuits électroniques et, plus particulièrement un circuit de protection d'un commutateur de puissance contre des surcharges. La présente description s'applique plus particulièrement à un commutateur d'alimentation d'une charge continue.

### Exposé de l'art antérieur

Les commutateurs de puissance électroniques, réalisés en matériaux semiconducteurs (par exemple, les transistors MOS de puissance) sont largement utilisés pour commander l'alimentation de charges à partir d'une source d'alimentation continue, par exemple une batterie. Dans un réseau électrique alimenté par une batterie, par exemple le réseau électrique d'un véhicule automobile, on trouve de nombreux commutateurs de puissance, servant à alimenter diverses charges. Les commutateurs, associés aux charges qu'ils commandent, sont connectés en parallèle sur une ou plusieurs lignes électriques véhiculant le courant continu.

Afin de protéger les commutateurs de puissance contre d'éventuelles surcharges continues, chaque commutateur ou groupe de commutateurs est généralement associé à un circuit de protection contre des surcourants en cas de court-circuit de la charge.

Le document WO 2014/199100 décrit un dispositif et méthode de protection contre les perturbations électriques, d'un dispositif monophasé alimenté par une ligne à partir d'un transformateur triphasé.

Le document FR-A-2 895 115 décrit un détecteur de pics parasites dans l'alimentation d'un circuit intégré.

Le document EP-A-0 678 751 décrit un dispositif de détection de la variation non transitoire d'une tension d'alimentation.

Le document US2017/033552 décrit un circuit de protection basé sur un calcul d'énergie dissipée dans un transistor de puissance.

Le document EP0546963 décrit un circuit de protection en série contre des surtensions.

Le document US2014/055119 décrit l'alimentation d'une charge à un potentiel flottant.

### Résumé

L' invention prévoit un module de commande tel que défini par la revendication 1 et les revendications dépendantes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon très schématique et sous forme de blocs, un exemple de réseau électrique auquel s'appliquent les modes de réalisation décrits ;
la figure 2 représente, de façon très schématique, un exemple de module de commande d'une charge connectée au réseau de la figure 1 ;
la figure 3 représente, de façon très schématique et sous forme de blocs, un mode de réalisation d'un circuit d'ajustement d'un seuil de détection d'un détecteur de surcharges ; et
les figures 4A et 4B illustrent, par des chronogrammes, le fonctionnement d'un circuit d'ajustement d'un seuil d'un détecteur de surcharges.

### Description détaillée

De mêmes éléments ont été désignés par de mêmes références aux différentes figures qui ont été tracées, en particulier pour les chronogrammes, sans respect d'échelle. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation qui vont être décrits ont été représentés et seront détaillés. En particulier, les circuits ou les charges commandés par des commutateurs de puissance et protégés par des circuits de protection tels que décrits, n'a pas été détaillés, les modes de réalisation décrits étant compatibles avec les applications usuelles.

Sauf précision contraire, lorsque l'on fait référence à deux éléments connectés entre eux, cela signifie directement connectés sans élément intermédiaire autre que des conducteurs, et lorsque l'on fait référence à deux éléments reliés entre eux, cela signifie que ces deux éléments peuvent être directement reliés (connectés) ou reliés par l'intermédiaire d'un ou plusieurs autres éléments.

Dans la description qui suit, sauf précision contraire, les expressions "approximativement", "sensiblement", et "de l'ordre de" signifient à 10 % près, de préférence, à 5 % près.

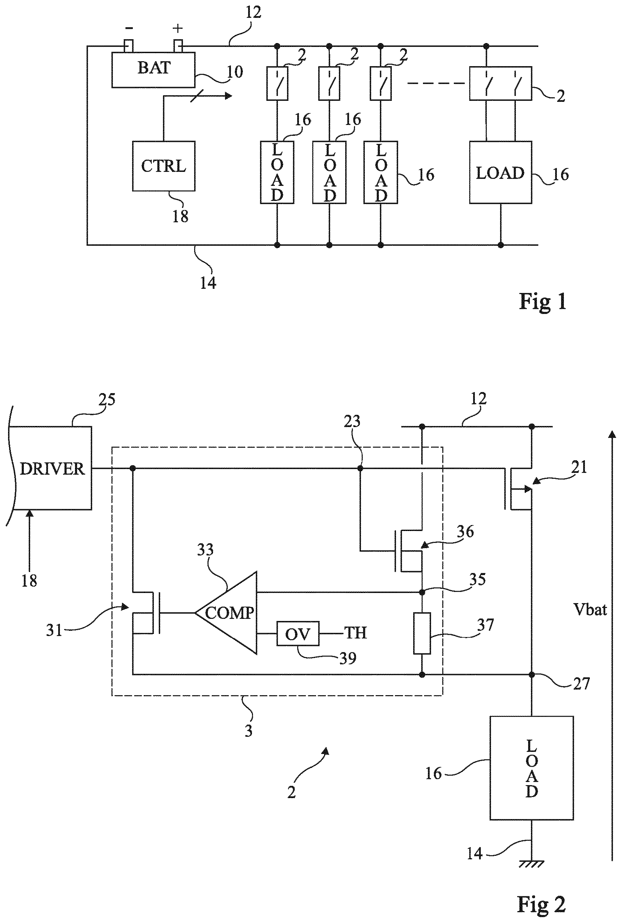

La figure 1 représente, de façon très schématique et sous forme de blocs, un exemple de réseau électrique auquel s'appliquent les modes de réalisation décrits.

On considère ci-après un exemple d'application au domaine automobile et à son réseau électrique continu, alimenté à partir d'une ou plusieurs batteries. Toutefois, tout ce qui est décrit par la suite s'applique plus généralement à tout réseau électrique dans lequel des problèmes similaires se posent.

Dans un véhicule automobile, une ou plusieurs batteries 10 (BAT) sont connectées à des bus d'alimentation constitués d'un bus 12 à un potentiel positif par rapport à un potentiel de référence, et d'un bus 14 de référence ou de masse connecté au châssis du véhicule. Différentes charges électriques 16 (LOAD) sont reliées, par l'intermédiaire de modules de commande 2, aux bus d'alimentation 12 et 14. Chaque module 2 comporte un ou plusieurs commutateurs de puissance de commande de la charge correspondante. Les charges sont, par exemple, des circuits de démarrage, des circuits de gestion moteur (allumage, injection), divers calculateurs, des circuits d'éclairage et de signalisation, des circuits d'alimentation de moteurs (essuie-glace, lèves vitres, sièges, etc.), des circuits de confort et d'accessoires (chauffage, ventilation, verrouillage des portes, etc.), etc. Les commutateurs des modules 2 sont commandés manuellement ou à partir d'une centrale 18 de commande (CTRL).

L'ensemble des charges 16 et leurs commutations respectives engendrent des perturbations électriques sur les bus d'alimentation 12 et 14. En particulier, les commutations des différentes charges engendrent des surtensions au niveau des différents modules et charges reliés aux bus 12 et 14.

Les modules 2 sont généralement équipés de circuits de protection contre d'éventuelles surcharges à l'état passant afin d'éviter la destruction des commutateurs de puissance suite à une surchauffe. En effet, les surtensions susceptibles d'être présentes sur les bus d'alimentation 12 et 14 peuvent atteindre la centaine de volts alors que la tension nominale de fonctionnement est de l'ordre de la douzaine ou quinzaine de volts. On prévoit de limiter le courant dans le commutateur de puissance du module afin de réduire la puissance et d'éviter sa destruction. Pour cela, chaque commutateur ou groupe de commutateurs est associé à un circuit de protection ayant pour fonction de réduire la tension de commande du commutateur afin de réduire son courant.

La figure 2 représente, de façon très schématique, un exemple de module 2 de commande en alimentation d'une charge 16. Le module 2 comporte un commutateur de puissance 21 associé à un circuit 3 de protection contre des surcharges à l'état passant.

On suppose le cas d'un commutateur de puissance 21 de type transistor MOS de puissance. Le transistor 21 est en série avec la charge 16 qu'il commande entre les bus 12 et 14 d'application d'une tension de batterie Vbat. La grille 23 du transistor 21 est connectée en sortie d'un circuit de commande 25 (DRIVER) . Selon le type de charge 16, le circuit 25 commande le commutateur 21 en tout ou rien ou de façon variable en ajustant la tension de grille du transistor 21. Le circuit 25 reçoit une consigne manuelle ou électrique provenant du circuit 18.

Le circuit de protection 3 a pour rôle de moduler la tension de grille 23 du transistor 21 en fonction de la tension drain-source aux bornes de ce transistor 21. Dans une réalisation simplifiée, cette modulation est en tout ou rien, c'est-à-dire que le circuit 3 force le blocage du transistor 21 en cas de surtension à ses bornes. De préférence, la modulation de la tension de grille du transistor 21 est analogique ou graduelle (par paliers). Pour cela, le circuit de protection 3 comporte un commutateur 31, typiquement un transistor MOS, reliant grille 23 et source 27 du transistor 21. Le rôle du transistor 31 est, quand il est passant, d'abaisser la tension grille-source du transistor 21 afin de réduire son courant drain-source et, ainsi, la puissance dissipée dans sa résistance drain-source à l'état passant. Le transistor 31 est commandé, par exemple, par un comparateur 33 (COMP) d'une information représentative du courant drain-source du transistor 21 à un seuil TH. Une première borne du comparateur 33 est connectée au point milieu 35 d'une association en série d'un transistor MOS 36 avec une résistance 37 en série entre drain et source du transistor 21, c'est-à-dire entre le bus 12 et la source 27. Une deuxième borne du comparateur 33 reçoit le seuil TH de comparaison de la tension du point 35. Quand la tension du point 35 excède le seuil TH, la sortie du comparateur 33 commute pour rendre le transistor 31 passant. La résistance drain-source à l'état passant du transistor 31 détermine la diminution de la tension grille-source du transistor 21, donc du courant dans le module 2.

Le circuit de la figure 2 est un exemple et on peut trouver d'autres structures de circuits de protection basées sur le principe d'une comparaison du courant qui traverse le transistor de puissance 21 ou de la tension à ses bornes, à un seuil pour déclencher une limitation du courant qui le traverse.

Le fait de limiter ou de couper le courant du transistor 21 quand on détecte une augmentation de la tension peut s'avérer problématique lorsque la diminution du courant est dépendante de la tension d'alimentation. En effet, si l'appel de courant par le module diminue, cela provoque, en raison de l'inductance de ligne des bus 12 et 14 qui n'est pas négligeable, une augmentation de la tension Vbat. Par conséquent, cette augmentation risque de provoquer une nouvelle diminution du courant ou la coupure d'autres modules et ainsi de suite dans un effet boule de neige.

Par ailleurs, divers phénomènes peuvent être à l'origine d'une surtension. Par exemple, en cas de court-circuit au niveau de la charge 16 commandée par le commutateur 21, le courant dans le commutateur 21 augmente brusquement ainsi que la tension à ses bornes. Une autre situation possible est une surtension au niveau du bus 12. Une telle surtension peut provenir de commutations des autres charges connectées sur le réseau, en particulier en raison du comportement inductif du réseau susmentionné.

La protection d'un module sur un réseau fortement perturbé comme le réseau électrique d'un véhicule doit respecter plusieurs contraintes. Outre le fait de ne pas être sensible aux oscillations de la tension Vbat dues aux commutations des différents modules, la protection ne doit pas se déclencher sur des phénomènes transitoires tels que, par exemple, de brusques augmentations temporaires liées aux courants d'appel lors de la mise sous tension de certaines charges.

Typiquement, dans l'exemple d'application à un réseau électrique d'un véhicule alimenté par une batterie dont la tension nominale est de 12 volts, des normes fixent des plages de fonctionnement dans lesquelles les charges doivent pouvoir être commutées ainsi que des durées de phénomènes transitoires acceptables. Par exemple, une charge doit pouvoir être allumée sous une tension pouvant atteindre jusqu'à environ 16 volts. De plus, la mise en route d'une charge doit pouvoir être effectuée avec des courants d'appel atteignant une dizaine de fois la valeur du courant nominal de la charge.

Selon l'invention telle que définie dans les revendications, on prévoit de modifier le seuil TH de déclenchement, afin de tenir compte de ces contraintes.

Dans l'exemple de la figure 2, cette fonction est remplie en modulant la valeur du seuil TH par un signal OV (bloc 39) indicateur d'une surtension. Un exemple de génération du signal OV est décrit en relation avec les figures suivantes. Dans un mode de réalisation simplifié, on peut prévoir d'activer ou de désactiver (en tout ou rien) la protection en fonction du signal OV. Pour une commutation en tout ou rien, on prévoit par exemple un seuil TH nul.

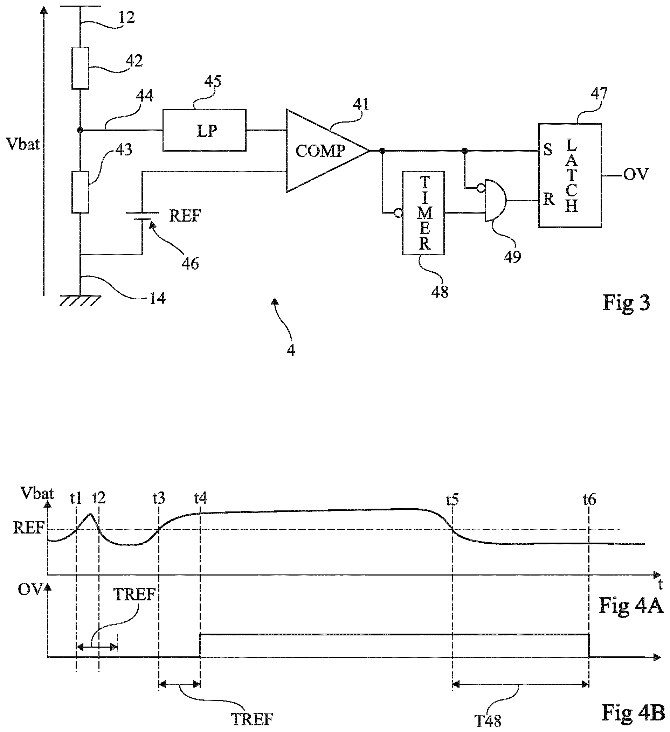

La figure 3 représente, de façon très schématique et sous forme de blocs, un mode de réalisation d'un circuit 4 d'ajustement d'un seuil de détection d'un détecteur de surcharges.

La représentation de la figure 3 est fonctionnelle. Ses différents éléments pourront être réalisés de façon matérielle ou logicielle pourvu de respecter la fonction décrite.

Le circuit 4 de la figure 3 fournit le signal OV indicateur de la présence d'une surtension à considérer par le circuit 3. Typiquement, le signal OV est destiné à conditionner la valeur du seuil TH du circuit de protection, par exemple du type du circuit 3 de la figure 2.

Dans l'exemple de la figure 3, le circuit 4 comporte un comparateur 41 (COMP) d'une information représentative de la tension Vbat à une référence ou seuil REF. Le seuil REF est fixe. L'information représentative de la tension Vbat est, de façon simplifiée et schématique, obtenue par un pont diviseur résistif, constitué de deux éléments résistifs 42 et 43 en série entre les bus 12 et 14. Le point milieu 44 de cette association en série fournit une information instantanée représentative de la tension Vbat. Cette information est filtrée par une fonction passe-bas 45 (LP), de constante de temps TREF, avant d'atteindre le comparateur 41 afin d'éliminer les variations transitoires. Le niveau REF est fixé par une source de tension 46 de valeur fixe.

La sortie du comparateur 41 fournit un signal numérique, à deux niveaux dans l'exemple de la figure 3. L'information fournie par le comparateur 41 est mémorisée, par exemple dans une bascule 47 (LATCH) dont la sortie fournit la valeur OV. La sortie du comparateur 41 active, sur front montant, l'entrée S de mise à 1 de la bascule 47. La bascule 47 est réinitialisée à condition que le niveau de la tension Vbat soit redescendu depuis un certain temps. Pour cela, la sortie du comparateur 41 active, sur front descendant, un compteur temporel ou temporisation 48 (TIMER) apportant un retard T48. La sortie du compteur 48 est combinée avec l'inverse de la sortie du comparateur 41 par une porte 49 de type ET, dont la sortie est reliée à une borne R de remise à zéro de la bascule 47.

En variante, la fonction de filtre passe-bas 45 peut être réalisée par un compteur temporel en sortie du comparateur 41. La sortie de ce compteur bascule alors seulement si la sortie du comparateur 41 indique un dépassement du seuil REF pendant une durée supérieure à une durée de référence TREF, le compteur étant réinitialisé dès que la sortie du comparateur 41 bascule dans l'état de repos. La durée TREF est choisie en fonction des perturbations transitoires dont on souhaite ne pas tenir compte. A titre d'exemple particulier de réalisation, la durée TREF est de quelques microsecondes et la durée T48 est de l'ordre de quelques dizaines de microsecondes.

Les figures 4A et 4B illustrent, par des chronogrammes, le fonctionnement du circuit de la figure 3. La figure 4A illustre un exemple d'allure de la tension Vbat. La figure 4B illustre l'allure correspondante du signal OV.

En présence de surtensions de courte durée (par exemple entre des instants t1 et t2), c'est-à-dire d'une durée inférieure à la constante de temps du filtre 45, rien ne se passe en sortie du comparateur 41.

Contrairement à un détecteur de pics parasites, le filtrage opéré ici permet de ne tenir compte que des variations non transitoires.

Si la surtension (par exemple à partir d'un instant t3) dure suffisamment longtemps, c'est-à-dire plus que la constante de temps TREF apportée par le filtre 45, l'entrée S de mise à 1 de la bascule 47 est activée (instant t4) à l'issue du temps TREF et sa sortie OV bascule (arbitrairement vers l'état haut).

Quand la surtension disparait (instant t5), le compteur temporel 48 est déclenché et, si la surtension ne réapparait pas avant l'expiration de la temporisation T48, la bascule 47 est réinitialisée (instant t6) .

Le signal OV est utilisé pour ajuster la valeur du seuil TH (figure 2). Dans l'exemple représenté, cet ajustement s'effectue entre deux valeurs, respectivement haute et basse. Cela revient à ne prendre en compte une surtension que quand elle est validée par le circuit 4. En l'absence de surtension, la valeur du seuil TH est supérieure à sa valeur en présence d'une surtension.

Un avantage par rapport à un circuit de protection qui tiendrait compte de caractéristiques électriques de l'élément protégé, le fait de ne pas se préoccuper de telles caractéristiques, mais de tenir compte des variations de la tension d'alimentation, permet de se prémunir de variations dues à des perturbations qui ne sont pas liées aux caractéristiques électriques du commutateur protégé.

Selon un autre mode de réalisation, le circuit 4 est utilisé directement en circuit de protection pour commuter le transistor 31 de la figure 2. Le comparateur 41 joue alors le rôle du comparateur 33 et le signal OV est appliqué sur la grille du transistor 31. Le pont diviseur 42-43 remplace le pont diviseur 36-37.

Selon un autre mode de réalisation, on prévoit plusieurs références de tension auxquelles sont affectées différents niveaux de réduction du courant dans le transistor 21. Par exemple, la valeur du courant est divisée par deux entre 16 et 20 volts, puis par quatre au-delà de 20 volts. Pour cela, on commande le transistor 31 de façon analogique.

Un avantage des modes de réalisation décrits est qu'il est désormais possible de :
- ne pas tenir compte des surtensions transitoires présentes sur le bus ; et
- déconnecter le module en cas de court-circuit de la charge qu'il commande, sans nuire au fonctionnement des autres modules.

Un autre avantage est que le circuit de protection et de détection de surtensions peut être intégré avec le transistor 21 dans le module de commutation 2.

Un autre avantage est que la solution proposée peut être réalisée au niveau de chaque module 2 (figure 1). Ainsi, elle est compatible avec les réseaux existants qui peuvent comporter à la fois des modules usuels et des modules améliorés tels que décrits.

Des modes de réalisation particuliers ont été décrits. Diverses variantes et modifications apparaîtront à l'homme de l'art selon la formulation des revendications.

En particulier, le choix des durées TREF et T48 dépendent de l'application et pourront varier. Ces durées peuvent même varier d'un module à un autre. Par ailleurs, on peut réaliser la fonction de détection décrite de façon analogique, numérique ou mixte. De plus, bien que l'on ait décrit une solution dans laquelle les modules de commande sont directement connectés à l'un des rails d'alimentation, certains modules peuvent y être reliés par l'intermédiaire d'autres éléments, par exemple, être entre deux charges connectées aux rails d'alimentation. En outre, on a pris pour exemple le cas d'un commutateur de puissance connecté au rail d'alimentation positif, mais tout ce qui a été décrit se transpose sans difficulté à des modules dont les commutateurs de puissance sont connectés au rail de référence ou négatif.

## Revendications

1. Module de commande (2), comportant :
au moins un commutateur (21) relié à un premier rail d'alimentation, le commutateur étant en série avec une charge (16) entre le premier rail et un deuxième rail et étant configuré pour commander ladite charge (16), entre lesquels est appliquée une tension d'alimentation continue (Vbat) ; et
un circuit (3) de protection du commutateur, ledit circuit étant relié au premier rail,
dans lequel le circuit de protection est configuré pour moduler un signal de commande du commutateur (21) pour régler le courant qui le traverse à l'état passant
**caractérisé en ce que** le circuit de protection comporte :
un premier circuit de détection configuré pour détecter une surcharge aux bornes du commutateur par rapport à un premier seuil (TH) ; et
un deuxième circuit (4) d'ajustement de la valeur du premier seuil (TH) en fonction de variations de la tension d'alimentation (Vbat), le deuxième circuit étant configuré pour :
comparer une information représentative de la tension d'alimentation par rapport à un deuxième seuil (REF) ; et
modifier la valeur du premier seuil en cas de dépassement du deuxième seuil pendant une durée supérieure à une durée de référence (TREF).

2. Module (2) selon la revendication 1, dans lequel ladite tension d'alimentation est fournie par une ou plusieurs batteries d'un véhicule automobile.

3. Module (2) selon la revendication 1 ou 2, dans lequel le premier circuit de détection d'une surcharge comporte un élément de comparaison (33) d'une information représentative du courant dans le commutateur (21) audit premier seuil (TH).

## Patentansprüche

1. Steuermodul (2), das Folgendes aufweist:
mindestens einen Schalter (21), der mit einer ersten Stromversorgungsschiene verbunden ist, wobei der Schalter in Reihe mit einer Last (16) zwischen der ersten Schiene und einer zweiten Schiene liegt, an die eine Versorgungsgleichspannung (Vbat) angelegt ist, und der zur Steuerung der Last (16) konfiguriert ist; und
eine Schutzschaltung (3) zum Schützen des Schalters (21), wobei die Schutzschaltung mit der ersten Schiene verbunden ist,
wobei die Schutzschaltung so konfiguriert ist, dass sie ein Steuersignal des Schalters (21) moduliert, um den Strom zu regulieren, der im eingeschalteten Zustand durch diesen fließt;
**dadurch gekennzeichnet, dass** die Schutzschaltung Folgendes aufweist:
eine erste Schaltung zum Detektieren, die so konfiguriert ist, dass sie eine Überlast an den Anschlüssen des Schalters in Bezug auf einen ersten Schwellenwert (TH) erfasst; und
eine zweite Schaltung (4) zum Einstellen des Wertes des ersten Schwellenwerts (TH) gemäß Änderungen der Versorgungsspannung (Vbat), wobei die zweite Schaltung konfiguriert ist, um:
eine für die Versorgungsspannung repräsentative Information mit einem zweiten Schwellenwert (REF) zu vergleichen; und
den Wert des ersten Schwellenwerts zu modifizieren, wenn der zweite Schwellenwert für eine Dauer von mehr als einer Referenzdauer (TREF) überschritten wird.

2. Modul (2) nach Anspruch 1, wobei die Versorgungsspannung von einer oder mehreren Batterien eines Kraftfahrzeugs bereitgestellt wird.

3. Modul (2) nach Anspruch 1 oder 2, wobei die erste Schaltung zum Detektieren einer Überlast ein Element (33) zum Vergleichen einer für den Strom im Schalter (21) repräsentativen Information mit dem ersten Schwellenwert (TH) enthält.

## Claims

1. Control module (2), including:
at least one switch (21) linked to a first power supply rail, the switch being in series with a load (16) between the first rail and a second rail between which is applied a dc supply voltage (Vbat), and being configured for controlling said load (16); and
a circuit (3) for protecting the switch (21), said circuit being linked to the first rail,
wherein the circuit for protecting is configured to modulate a control signal of the switch (21) to regulate the current that flows therethrough in the on state,
**characterized in that** the protecting circuit comprises:
a first circuit for detecting configured to detect an overload across the terminals of the switch with respect to a first threshold (TH); and
a second circuit (4) for adjusting the value of the first threshold (TH) according to variations in the supply voltage (Vbat), the second circuit being configured to:
compare an information representative of the supply voltage with a second threshold (REF); and
modify the value of the first threshold if the second threshold is exceeded for a duration over a reference duration (TREF).

2. Module (2) according to claim 1, in which said supply voltage is provided by one or several batteries of an automobile vehicle.

3. Module (2) according to Claim 1 or 2, in which the first circuit for detecting an overload includes an element (33) for comparing information representative of the current in the switch (21) with said first threshold (TH).
